# EUROPÄISCHE PATENTSCHRIFT

(11) **EP 0 771 475 B1**
(45) Veröffentlichungstag und Bekanntmachung des Hinweises auf die Patenterteilung: **21.12.2005**
(21) Anmeldenummer: 96919747.4
(22) Anmeldetag: 09.05.1996
(51) Int. Cl.: H01L 31/0352, H01L 31/103

(54) **STRAHLUNGSEMPFINDLICHES DETEKTORELEMENT**
RADIATION-SENSITIVE DETECTOR ELEMENT
ELEMENT DETECTEUR PHOTOSENSIBLE

(30) Priorität: 19.05.1995 DE 19518423
(43) Veröffentlichungstag der Anmeldung: 07.05.1997
(73) Patentinhaber: Dr. Johannes Heidenhain GmbH, 83292 Traunreut (DE)
(72) Erfinder: SPECKBACHER, Peter, D-84558 Kirchweidach (DE)
(86) Internationale Anmeldenummer: PCT/EP1996/001976
(87) Internationale Veröffentlichungsnummer: WO 1996/036999

(56) Entgegenhaltungen:
- EP-A- 0 444 370
- EP-A- 0 452 588
- EP-A- 0 601 561
- DE-A- 2 115 305
- DE-A- 4 102 285
- DE-A- 4 102 286
- US-A- 4 838 952
- US-A- 4 897 123
- PATENT ABSTRACTS OF JAPAN vol. 007, no. 204 (E-197), 9.September 1983 & JP 58 100467 A (MATSUSHITA DENKI SANGYO KK), 15.Juni 1983,
- KITO Y.: 'HIGH-SPEED FLIP-CHIP INP/INGAAS AVALANCHE PHOTODIODES WITH ULTRALOW CAPACITANCE AND LARGE GAIN-BANDWIDTH PRODUCTS' IEEE PHOTONICS TECHNOLOGY LETTERS Bd. 3, Nr. 12, 01 Dezember 1991, IEEE INC., NEW YORK, US, Seiten 1115 - 1116, XP000243979

## Beschreibung

Die vorliegende Erfindung betrifft ein strahlungsempfindliches Detektorelement.

Bekannte strahlungsempfindliche Detektorelemente, insbesondere Photoelemente, dienen zur Umwandlung elektromagnetischer Strahlungssignale in elektrische Signale. Für derartige Detektorelemente existieren vielfältige Einsatzmöglichkeiten. Erwähnt sei in diesem Zusammenhang etwa der Einsatz in der Abtasteinheit von lichtelektrischen Positionsmeßeinrichtungen. Dort dienen die vorgesehenen Detektorelemente zum Erfassen der amplitudenmodulierten Strahlungssignale, die beim Relativversatz einer Maßstabs-Teilung und einer Abtastplatte resultieren. Gefordert wird ein möglichst kompakter Aufbau der Abtasteinheit, das heißt es ergeben sich bestimmte Anforderungen an die darin eingesetzten strahlungsempfindlichen Detektorelemente. Darüberhinaus ist auch eine möglichst einfache Fertigung der verwendeten Bauelemente, insbesondere der Detektorelemente, wünschenswert.

Die üblichen strahlungsempfindlichen Detektorelemente weisen einen aktiven Bereich auf, in dem Schichten mit unterschiedlichen Ladungsträgerkonzentrationen benachbart angeordnet sind, beispielsweise Halbleiterschichten unterschiedlicher Dotierung. Es handelt sich hierbei etwa um pn-Übergänge, in denen innerhalb eines aktiven Bereiches bzw. innerhalb einer sich ausbildenden Raumladungszone durch die einfallende elektromagnetische Strahlung freie Ladungsträger erzeugt werden. So bestehen handelsübliche Photoelemente auf Silizium-Basis aus n-dotiertem Silizium, in dessen Oberfläche eine dünne Schicht p-dotiertes Silizium eindiffundiert wurde. Der erwähnte aktive Bereich, in dem beim Einfall von Strahlung eine Ladungsträgertrennung erfolgt, liegt hierbei knapp unterhalb der strahlungsempfindlichen Oberfläche. Um die derart erzeugten elektrischen Signale an eine Auswerteschaltung zu übermittleln, sind am Detektorelement angeordnete Kontaktelemente oder -Elektroden erforderlich.

Derart aufgebaute strahlungsempfindliche Detektorelemente können in der Abtasteinheit nunmehr beispielsweise in eine Leiterplatte integriert werden, auf der darüberhinaus auch Teile der nachgeordneten Auswerteelektronik angeordnet sind. Es bietet sich somit eine Ausbildung der Detektorelemente als sogenannte SMD-Elemente (Surface Mounted Devices) an. Hierunter versteht man miniaturisierte Bauelemente, die direkt auf die Oberfläche von Leiterplatten oder anderen Substraten montiert werden können. Bei einer derartigen Ausgestaltung der strahlungsempfindlichen Detektorelemente resultieren jedoch gewisse Anforderungen insbesondere an die Kontaktierung. Als vorteilhaft erweist sich dabei, wenn die Detektorelemente auf derjenigen Seite mit geeigneten Anschlußkontakten versehen werden, die gegenüberliegend zur strahlungsempfindlichen Oberfläche angeordnet ist.
Eine solche rückseitige Kontaktierung ist bei Solarzellen beispielsweise aus der US 4,897,123 oder aber aus der EP 0 452 588 grundsätzlich bekannt. In der US 4,897,123 wird hierzu vorgeschlagen, einen der beiden Kontakte über eine klammerartige Verbindung von der strahlungsempfindlichen Oberfläche in Richtung der gegenüberliegenden Oberfläche, d.h. zur Rückseite zu führen. Der zweite Kontakt befindet sich bereits auf dieser gegenüberliegenden Oberfläche, so daß eine Kontaktierung von der Rückseite des Bauelementes her möglich ist. Nachteilig hieran erweist sich insbesondere der fertigungstechnische Aufwand zur Ausbildung der klammerartigen Verbindung zwischen Vorder- und Rückseite des Bauelementes.

Aus der EP 0 452 588 ist bekannt, mittels geeignet dimensionierter Durchbrüche durch den aktiven Bereich eine rückseitige Kontaktierung zu ermöglichen, d.h. die Anschlußkontakte auf derjenigen Seite vorzusehen, die der strahlungsempfindlichen Seite gegenüberliegt. Bei einer derartigen rückseitigen Kontaktierung wird aufgrund der vorgesehenen Durchbrüche die Kristall-Struktur der verschiedenen Halbleiterschichten unerwünscht beeinflußt bzw. gestört.

Photoelemente sowie IR-Detektorelemente mit rückseitig angeordneten Kontaktelektroden sind desweiteren aus den Veröffentlichungen R.S.Sussmann et al. "Ultra-Low-Capacitance Flip-Chip-Bonded GalnAs PIN Photodetector For Long-Wavelength High-Data-Rate Fibre-Optic Systems", Electronics Letters July 1985 Vol. 21, No. 14, S. 593-595 sowie "SDI needs Alter detector's mission", Photonics Spectra, Januar 1986, S. 86, 88 bekannt. Details zur Herstellung derartiger Detektorelemente finden sich in diesen Veröffentlichungen jedoch nicht.

Eine rückseitig kontaktierbare Solarzelle ist ferner aus der US 4,838,952 bekannt. Zur Kontaktierung des pn-Übergangsbereiches, der sich unmittelbar unterhalb derjenigen Oberfläche ausbildet, auf die die Strahlung einfällt, werden in das Basissubstrat von der Rückseite her Löcher eingebracht und mit leitendem Kontaktierungsmaterial verfüllt. Problematisch bzw. fertigungstechnisch aufwendig ist hierbei der Prozess des Einbringens der Löcher in das Basisubstrat.

Weiterhin ist eine rückseitig kontaktierbare Photodiode aus der Veröffentlichung "High-Speed Flip-Chip InP/InGaAs Avalanche Photodiodes with Ultralow Capacitance and Large Gain-Bandwidth Products", Y.Kito et al. in IEEE Photonics Technology Letters, Vol. 3, No. 12, S. 1115 - 1116, 1991 bekannt. Hierbei wird die zu detektierende Strahlung zur Erhöhung der Quantenausbeute mittels einer Mikrolinse auf der Oberseite eines InP-Substrates durch das Substrat in Richtung eines reflektierenden Kontaktes fokussiert und dann in Richtung eines sich ausbildenden pn-Überganges zurückreflektiert. Insgesamt resultiert ein aufwendig zu fertigendes Photoelement.

Aus der DE 41 02 285 ist schließlich ein Verfahren zur Herstellung einer Membrandiode bekannt, bei dem aus einem einkristallinen Material durch mikromechanische Ätztechniken eine Membranstruktur erzeugt wird. Zur Kontaktierung sind auf Vorder- und Rückseite der Membrandiode entsprechende Metallkontakte erforderlich, d.h. als SMD-Bauteil ist die offenbarte Membrandiode nicht geeignet.

Aufgabe der vorliegenden Erfindung ist es, ein strahlungsempfindliches Detektorelement zu schaffen, welches über die SMD-Technik montierbar und einfach bzw. kostengünstig zu fertigen ist. Gefordert ist dabei insbesondere eine Möglichkeit zur Kontaktierung auf der Seite, die gegenüberliegend zu derjenigen Oberfläche angeordnet ist, auf die die einfallende Strahlung auftrifft.

Diese Aufgabe wird gelöst durch ein strahlungsempfindliches Detektorelement mit den Merkmalen des Anspruches 1.

Vorteilhafte Ausführungsformen des erfindungsgemäßen strahlungsempfindlichen Detektorelementes ergeben sich aus den Merkmalen in den von Anspruch 1 abhängigen Ansprüchen.

Die erfindungsgemäße Ausgestaltung des strahlungsempfindlichen Detektorelementes ermöglicht nunmehr die SMD-Montage auf einer Leiterplatte, da eine Kontaktierung des Detektorelementes von der Rückseite her möglich ist, d.h. von derjenigen Seite, die gegenüberliegend zur strahlungsempfindichen Seite angeordnet ist. Im Fall des Einsatzes des Detektorelementes innerhalb der Abasteinheit einer lichtelektrischen Positionsmeßeinrichtung lassen sich somit die erwähnten Anforderungen hinsichtlich des gewünschten geringen Platzbedarfes erfüllen.
Desweiteren ergeben sich Vorteile bei der Massenfertigung derartiger Bauelemente, wenn diese in sogenanten Batch-Prozessen analog zur Halbleiter-Fertigung hergestellt werden können. Hierbei werden auf einem einzigen Trägersubstrat, z.B. aus Silizium, eine große Anzahl identischer Bauelemente gleichzeitig fertigen.

Weitere Vorteile sowie Einzelheiten der erfindungsgemäßen Lösung ergeben sich aus der nachfolgenden Beschreibung mehrerer Ausführungsbeispiele anhand der beiliegenden Zeichnungen.

Dabei zeigt
- Figur 1: eine erstes Ausführungsbeispiel des erfindungsgemäßen strahlungsempfindlichen Detektorelementes;
- Figur 2a-2d: jeweils einen Verfahrensschritt zur Herstellung des Detektorelementes aus Figur 1;
- Figur 3: eine zweite Ausführungsform des erfindungsgemäßen strahlungsempfindlichen Detektorelementes;
- Figur 4a: eine weitere Ausführungsform des erfindungsgemäßen strahlungsempfindlichen Detektorelementes;
- Figur 4b: die Ausführung der Kontaktierung in der Ausführungsform der Figur 5a.

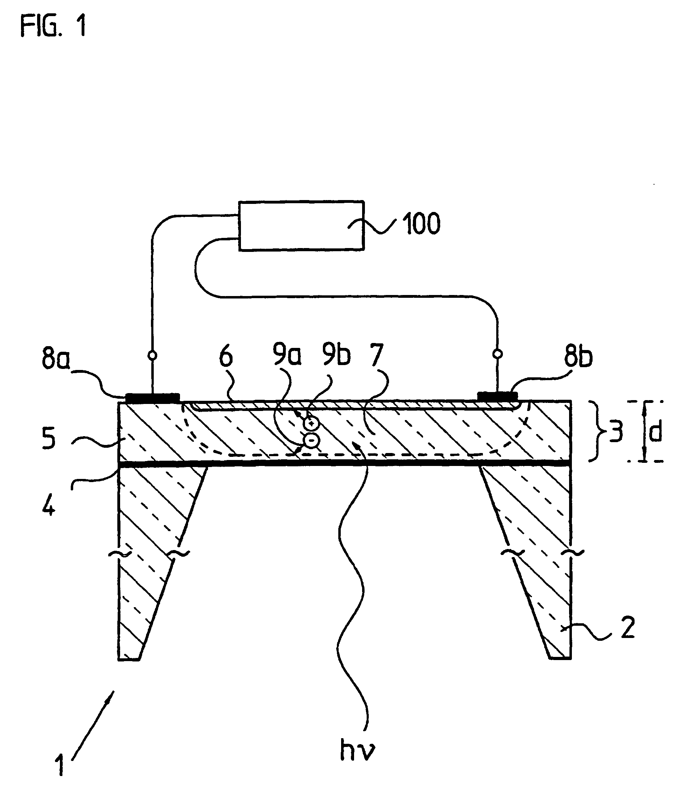

Figur 1 zeigt eine erste Ausführungsform des erfindungsgemäßen strahlungsempfindlichen Detektorelementes (1) in einer seitlichen Schnittdarstellung. Dieses umfaßt eine Trägerstruktur (2), auf der eine Schichtanordnung (3) mit mehreren unterschiedlichen Schichten (5, 6) aufgebracht ist, im dargestellten Ausführungsbeispiel mit zwei verschiedenen Schichten (5, 6). Die Oberseite des Detektoretementes (1) ist mit zwei Kontaktelementen (8a, 8b) versehen. Als Material für die Kontaktelemente (8a, 8b) ist in der dargestellten Variante Gold vorgesehen.
Die zu detektierende elektromagnetische Strahlung (hν) beaufschlagt demzufolge in der Darstellung der Figur 1 die Unterseite des Detektorelementes (1), d.h. die Unterseite fungiert als eigentliche strahlungsempfindliche Fläche. Die Kontaktelemente (8a, 8b) zur Verbindung des Detektorelementes (1) mit einer schematisiert dargestellten, nachgeordneten Auswerteschaltung (100) sind hingegen an der Oberseite vorgesehen, also an derjenigen Seite, die gegenüberliegend zur strahlungsempfindlichen Seite angeordnet ist. Diese Anordnung eignet sich wie vorab erläutert insbesondere zur gewünschten SMD-Montage des Bauelementes auf einer Leiterplatte und wird durch die nachfolgend beschriebenen, erfindungsgemäßen Maßnahmen ermöglicht.

Die auf der Trägerstruktur (2) befindliche Schichtanordnung (3) umfaßt zwei aneinandergrenzende Schichten (5, 6) bzw. Schichtbereiche, in denen unterschiedliche Ladungsträger jeweils in definierter Konzentration vorhanden sind. Als untere Schicht (5) ist eine n-dotierte Silizium-Halbleiterschicht vorgesehen, darüber befindet sich eine p-dotierte Silizium-Halbleiterschicht (6). Im Grenzbereich zwischen den beiden Schichten (5, 6) bildet sich eine Sperrschicht aus, die nachfolgend als aktiver Bereich (7) bezeichnet wird und die in der Darstellung der Figur 1 vergrößert eingezeichnet ist. Im aktiven Bereich (7) der Schichtanordnung (3) resultiert beim Einfall der elektromagnetischen Strahlung (hν) eine Erzeugung von Ladungsträgerpaaren (9a, 9b), die wiederum als elektrische Signale in der nachgeordneten Auswerteschaltung (100) detektiert werden können. Hierzu sind die beiden Halbleiterschichten (5, 6) auf der Oberseite mit den bereits erwähnten Kontaktelementen (8a, 8b) versehen.

Unterhalb der Schichtanordnung (3) mit den beiden verschieden dotierten Schichten (5, 6) ist noch eine weitere Schicht (4) vorgesehen, die als SiO₂-Schicht ausgebildet ist und deren Funktion im Verlauf der Beschreibung noch näher erläutert wird. An dieser Stelle sei lediglich erwähnt, daß diese Schicht (4) aufgrund der Einfallsrichtung der zu detektierenden Strahlung (hν) selbstverständlich durchlässig für die jeweilige Strahlungs-Wellenlänge λ sein muß.
Bei bekannten strahlungsempfindlichen Detektorelementen bzw. Photoelementen trifft die einfallende Strahlung (hν) üblicherweise von der entgegengesetzten Seite auf das Bauelement, d.h. auf der Seite der in der Regel dünneren der beiden Halbleiter-Schichten (6) auf, weshalb eine Kontaktierung von der Rückseite und damit die gewünschte SMD-Montage nicht möglich ist.

Erfindungsgemäß ist deshalb nunmehr vorgesehen, die Schichtanordnung (3) so zu dimensionieren, daß das Detektorelement (1) von der eigentlichen "Rückseite" mit der zu detektierenden Strahlung (hν) beaufschlagt werden kann. Die elektromagnetische Strahlung (hν) trifft demzufolge zunächst auf die dickere (5) der beiden Halbleiterschichten des pn-Überganges, bevor im aktiven Bereich (7) die Erzeugung von Ladungsträgern (9a, 9b) erfolgt. Hierzu muß insbesondere die Lage des aktiven Bereich (7) des strahlungsempfindlichen Detektorelementes (1) relativ zur stahlungsempfindlichen Oberfläche definiert eingestellt werden. Zur definierten Einstellung der räumlichen Ausdehnung bzw.. Lage des aktiven Bereiches (7) relativ zu den begrenzenden Oberflächen werden bevorzugterweise die Dotierungskonzentrationen in den beiden aneinandergrenzenden Schichten (5, 6) variiert. Je nach nach gewählter Konzentration bildet sich der aktive Bereich (7) geeignet aus.
Die Eindringtiefe der zu detektierenden Strahlung (hν) muß demzufolge ausreichen, um die Ladungsträgertrennung im aktiven Bereich (7) zu ermöglichen, auch wenn zunächst die dickere (5) der beiden Halbleiterschichten (5, 6) durchtreten wird, d.h. der Strahlungseinfall aus dieser Richtung erfolgt. Im dargestellten Ausführungsbeispiel der Figur 1 wurde hierzu die Dicke d der Schichtanordnung (3) derart dünn gewählt, daß die erwähnten Voraussetzungen erfüllt sind, d.h. die Ladungsträgertrennung im aktiven Bereich (7) erfolgt. Der aktive Bereich (7) nimmt in dieser Ausführungsform demzufolge fast die gesamte Dicke der Schichtanordnung (3) ein.
Da die unterhalb der Schichtanordnung (3) vorgesehene Schicht (4) transparent für die einfallende Strahlung (hν) ausgelegt ist, ist deren Dicke in diesem Zusammenhang von untergeordneter Bedeutung.

Bei einer zu detektierenden Wellenlänge von 830 nm ergibt sich auf Grundlage dieser Überlegungen bei den gewählten Materialien eine Schichtdicke d der beiden Halbleiterschichten (5, 6) in der Größenordnung 2-5 µm. Der aktive Bereich (7) bildet sich demzufolge in dieser Ausführungsform entsprechend der Darstellung nach Figur 1 nahezu in der gesamten Schichtanordnung (3) aus.

Analog hierzu ändern sich selbstverständlich die zu wählenden Parameter mit anderen Strahlungswellenlängen bzw. anderen Materialien. So ist es etwa auch möglich, dickere Schichtanordnungen einzusetzen, bei denen der aktive Bereich nicht die gesamte Schichtdicke ausmacht, sondern relativ zur strahlungsempfindlichen Oberfläche in Abhängigkeit der Strahlungswellenlänge passend eingestellt wird. Entscheidend ist wiederum, daß die Eindringtiefe der zu detektierenden Strahlung auf jeden Fall ausreicht, um durch die dickere Schicht hindurch in den aktiven Bereich bzw. in die sich ausbildende Sperrschicht oder Raumladungszone der benachbart angeordneten Schichten zu gelangen.

Zur Ermittlung der geeigneten Lage des aktiven Bereiches bzw. Dicken der Schichtanordnung ist auch in anderen Fällen die wellenlängenabhängige Absorptionscharakteristik dieser Materialien heranzuziehen. In diesem Zusammenhang sei beispielsweise auf eine entsprechende graphische Darstellung dieser Zusammenhänge für verschiedene geeignete Materialien in S.M. Sze, Physics of Semiconductor Devices, 2nd edition, New York 1981, S. 750, Figur 5 verwiesen.

Diese Überlegungen gelten selbstverständlich auch für andere Übergangs-Arten bei strahlungsempfindlichen Detektorelementen, also nicht nur für reine Halbleiter-Halbleiter-Übergänge, sondern beispielsweise auch für Schottky-Kontakte mit Metall-Halbleiter-Übergängen. Ebenso können selbstverständlich auch andere Halbleitermaterialien gewählt werden, wie GaAs, InP usw..

Um die Dicke d der Schichtanordnung (3) bzw. die Dicke der beiden Halbleiterschichten (5, 6) derart dünn einstellen zu können, erweisen sich für das in Figur 1 dargestellte Ausführungsbeispiel bestimmte fertigungstechnische Maßnahmen als vorteilhaft. So ist vorgesehen, daß die beiden Halbleiterschichten (5, 6) bzw. der aktive Bereich (7) durch eine Trennschicht (4) von der Trägerstruktur (2) separiert sind. Wie bereits angedeutet, ist die Trennschicht als SiO₂ - Schicht ausgebildet, die für die zu detektierende Wellenlänge von 830 nm durchlässig ist.

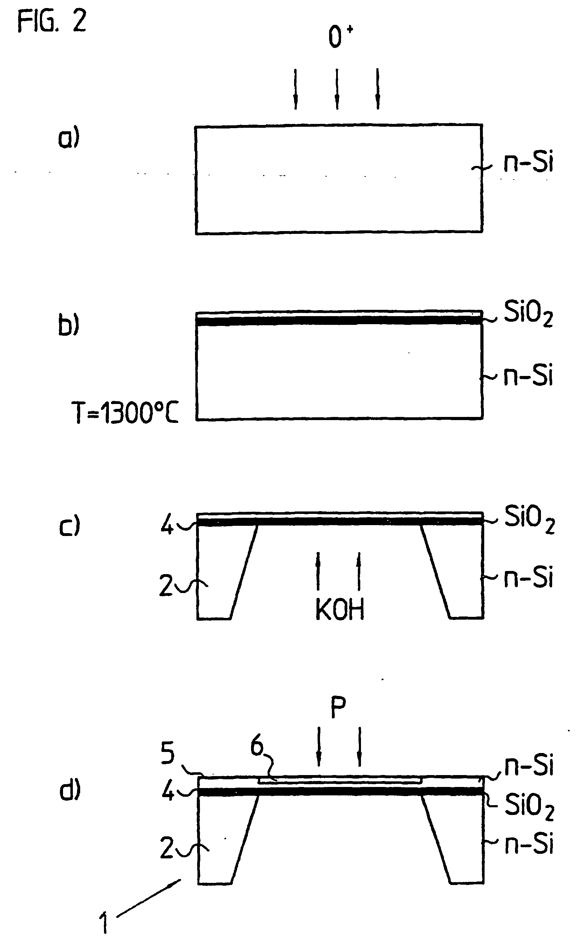

Bei der nachfolgend anhand der Figuren 2a-2d erläuterten Fertigung des erfindungsgemäßen Detektorelementes (1) fungiert diese Trennschicht (4) als Ätzstopschicht. Die Erzeugung dieser Schicht erfolgt im sogenannten SIMOX-Verfahren (Separation by Implanted Oxygen). Zu weiteren Details dieses Verfahrens sei beispielsweise auch auf die Veröffentlichung von A.Müller et al. mit dem Titel "Ein thermoelektrischer Infrarotsensor als Beispiel für den Einsatz von SIMOX-Substraten für die Herstellung von Sensoren und Mikrosystemen" in SENSOR 93, Kongreßband III, S. 238-245 verwiesen.
In Figur 2a ist ein erster Verfahrensschritt des Fertigungsprozesses dargestellt, bei dem eine Sauerstoff-Implantation in ein n-dotiertes, einkristallines Si-Substrat erfolgt. Im zweiten Verfahrensschritt der Figur 2b wird der knapp unterhalb der Oberfläche eingebrachte Sauerstoff in einem mehrstündigem Prozeß bei hohen Temperaturen von ca. 1300 °C getempert. Hierbei heilen Strahlungsschäden aus und es verbindet sich der implantierte Sauerstoff mit dem Silizium zur SiO₂-Schicht, die scharfe Übergänge zum benachbarten Si-Substrat aufweist. Typische Dicken der SiO₂-Schicht liegen in der Grössenordnung mehrerer hundert nm (Nanometer). Der Abstand der eingebrachten Schicht von der darüberliegenden Oberfläche beträgt ebenfalls einige hundert nm.
Im nachfolgenden Prozeßschritt der Figur 2c dient die SiO₂ -Schicht nunmehr als Trennschicht während eines Ätzprozesses, bei dem mittels Kalilauge (KOH) der untere Teil des Si-Substrates bis zur SiO₂-Trennschicht bzw. Ätzstopschicht selektiv weggeätzt wird, so daß die auch in Figur 1 erkennbare Trägerstruktur (2) resultiert, die das komplette Detektorelement (1) mechanisch stabilisiert. Im Fall einer runden Ausführung des Detektorelementes (1) ist die Trägerstruktur (2) demnach zylinderförmig ausgebildet; selbstverständlich sind aber auch andere Geometrien realisierbar. Der zentrale, freigeätzte Bereich des Detektorelementes (1) mit der begrenzenden SiO₂-Schicht fungiert nachfolgend als strahlungsempfindliche Oberfläche. Im Bereich der darunter befindlichen Ausnehmung kann zusätzlich noch ein - nicht dargestelltes - Füllmaterial eingebracht werden, das für die zu detektierende Strahlung transparent ist und eine zusätzliche mechanische Stabilisierung das Detektorelementes (1) bewirkt.
Im Prozeßschritt der Figur 2d wird schließlich mittels bekannter Diffusionstechniken in die oberhalb der Trennschicht befindliche dünne Silizium-Schicht eine räumlich begrenzte p-dotierte Zone (6) geringer Dicke eingebracht, so daß der bereits anhand von Figur 1 beschriebene Aufbau der Schichtanordnung resultiert. Typische Dicken dieser Schicht liegen etwa im Bereich mehrerer hundert nm.
Nicht mehr dargestellt ist die abschließende Kontaktierung der Oberseite mit den Kontaktelektroden, was über bekannte Bonding-Verfahren in Form von Sputtem oder Bedampfen erfolgt.
Neben der Verwendung einer SiO₂-Schicht als Trennschicht bzw. Ätzstopschicht im erfindungsgemäßen Detektorelement, ist es desweiteren möglich, alternativ zur Sauerstoff-Implantation eine Bor-Implantation vorzunehmen, so daß sich eine entsprechende Trennschicht in Form einer Silizium-BorVerbindung knapp unterhalb der Oberfläche ausbildet. Bei geeignet gewählter Bor-Konzentration, etwa im Konzentrations-Bereich 10²⁰ Atome/cm³, wirkt diese Schicht dann ebenfalls als Ätzstopschicht und eine Herstellung des erfindungsgemäßen Detektorelementes ist analog zu den Fertigungsschritten in den Figuren 2a - 2d möglich.

Eine Möglichkeit zur Optimierung des erfindungsgemäßen Detektorelementes hinsichtlich der verwendeten Wellenlänge besteht desweiteren darin, wenn in einem separaten Verfahrensschritt nach der erfolgten Sauerstoff- oder Bor-Implantation und dem nachfolgenden Temper-Prozess eine Siliziumschicht definierter Dicke auf die Ätzstopschicht epitaktisch aufgewachsen wird. Derart läßt sich die Dicke der Schichtanordnung und damit auch die Lage des aktiven Bereiches relativ zur strahlungsempfindlichen Oberfläche in der gewünschten Art und Weise einstellen. Dies ist insbesondere zur Anpassung der Dicke der Schichtanordnung an die Eindringtiefe der verwendeten elektromagnetischen Strahlung von Vorteil, da sich derart eine einfache Möglichkeit zur wellenlängen-optimierten Dimensionierung ergibt. Der aktive Bereich innerhalb der Schichtanordnung liegt somit immer in einer an die wellenlängenabhängige Eindringtiefe angepaßten Entfernung von der strahlungsempfindlichen Oberfläche. Die erforderliche p- und n-Dotierung der beiden Schichten erfolgt nach dem Epitaxie-Prozess durch entsprechende Diffusionsverfahren, bei denen in räumlich getrennten Bereichen der Schichtanordnung die verschiedenen Ladungsträger definiert eingebracht werden.

Darüberhinaus läßt sich eine Optimierung des erfindungsgemäßen Detektorelementes bei zu detektierender Strahlung im infraroten Spektralbereich auch dadurch erreichen, wenn in die epitaktisch aufgewachsene Silizium-schicht zusätzlich Germanium-Atome in einer definierten Konzentration eingebracht werden, so daß ein Si-Ge-Übergitter resultiert. In diesem Spektralbereich läßt sich die Detektorelement-Empfindlichkeit somit über die entsprechende Konzentration an eingebrachtem Germanium vorteilhaft beeinflußen.

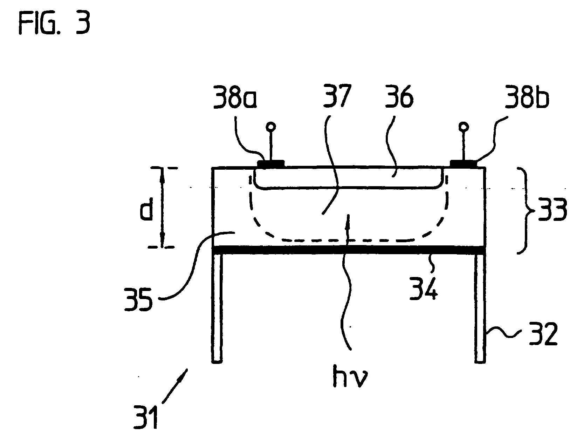

Eine zweite Ausführungsform des erfindungsgemäßen strahlungsempfindlichen Detektorelementes (31) sei im folgenden anhand von Figur 3 beschrieben. Analog zum ersten Ausführungsbeispiel ist die Dicke d der Schichtanordnung (33) mit den beiden unterschiedlich dotierten Halbleiterschichten (35, 36) und dem aktiven Bereich (37) derart dimensioniert, daß die strahlungsempfindliche Fläche des Detektorelementes (31) gegenüber derjenigen Fläche liegt, an der die Kontaktelemente (38a, 38b) in Form von Kontaktelektroden angeordnet sind. Es ist alternativ zur Ausführungsform aus Figur 1 jedoch nunmehr die Schichtanordnung (33) mit dem aktiven Bereich (7) als entsprechend dünne Membran ausgebildet. Die erforderliche Dotierung der Membran (33), d.h. die Ausbildung von p- und n-dotierten Schichten bzw. Bereichen ist bereits in der entsprechend den Anforderungen hergestellten Membran (33) enthalten.
Im Hinblick auf solche Halbleitermembranen sei etwa auf die Informationsschrift der Fa. *Virginia Semiconductor, Inc.* aus dem Mai 1992 verwiesen, in der derartige Membranen, ausgeführt als Silizium-Membranen, beschrieben werden.
Vorteilhaft an einer derartigen Ausführung der Schichtanordnung ist die Möglichkeit zur großflächigen und damit rationellen Fertigung der Halbleitermembranen (33) und damit auch der Detektorelemente. Grundsätzlich ist hierbei auch der Einsatz anderer Halbleiter-Membran-Materialien möglich.

Auf der der einfallenden Strahlung (hν) zugewandten Seite des Detektorelementes (31), ist im dargestellten Ausführungsbeispiel der Figur 3 desweiteren eine transparente Passivierungsschicht (34) angeordnet. Diese Passivierungsschicht (34) dient zur Stabilisierung der elektrischen Eigenschaften der Membran (33) bzw. des Bauelementes, d.h. zum Schutz gegen verschiedenste Umwelteinflüsse. Als Passivierungsschichten (34) eignen sich beispielsweise SiO₂ oder aber Si₃N₄, die jeweils aus der Gasphase auf die entsprechende Oberfläche abgeschieden werden können.

Zur weiteren mechanischen Stabilisierung ist in dieser Ausführungsform des erfindungsgemäßen Detektorelementes (31) vorgesehen, die Membran (33) inclusive der Passivierungsschicht (34) auf einem, z.B. zylinderförmigen, Trägerelement (32) anzuordnen. Hierbei erweist sich zudem als günstig, wenn das verwendete Trägerelement (32) den gleichen Wärmeausdehnungskoeffizienten aufweist wie die Membran (33), um eventuell auftretende mechanische Spannungen beim Erwärmen zu vermeiden. Im Fall einer Silizium-Membran (32) eignet sich hinsichtlich gleicher Wärmeausdehnungskoeffizienten demzufolge ein aus Silizium gefertigtes Trägerelement (32); alternativ hierzu wäre auch der Einsatz von Pyrex möglich.
Femer ist eine möglichst stabile mechanische Verbindung zwischen der Membran (33) und dem Trägerelement (32) vorteilhaft, um die Stabilität des Detektorelementes (31) gegen Erschütterungen und dgl. zu gewährleisten. Ein hierfür besonders geeignete Verbindungstechnologie ist das sogenannte "Anodic Bonding", bei dem unter dem Einfluß von definierten Temperaturen und/oder elektrischen Feldern eine Verbindung mit kristallinen Obergangstrukturen realisierbar ist. Geeignete Trägermaterialien auf Silizium-Basis für ein Verbinden mit Silizium-Membranen werden etwa von der Fa. *HOYA* angeboten. Hierzu sei auf die Firmendruckschrift "SD - 2 Glass for Anodic Bonding" verwiesen, in der ein hierfür geeignetes Trägermaterial beschrieben wird.

Bei den bislang beschriebenen Ausführungsbeispielen besteht jeweils desweiteren noch die Möglichkeit, in die Schichtanordnung mit dem aktiven Bereich weitere elektronische Bauelemente in integrierter Form einzubauen, beispielsweise Verstärker-Elemente oder aber Temperatursensor-Elemente.

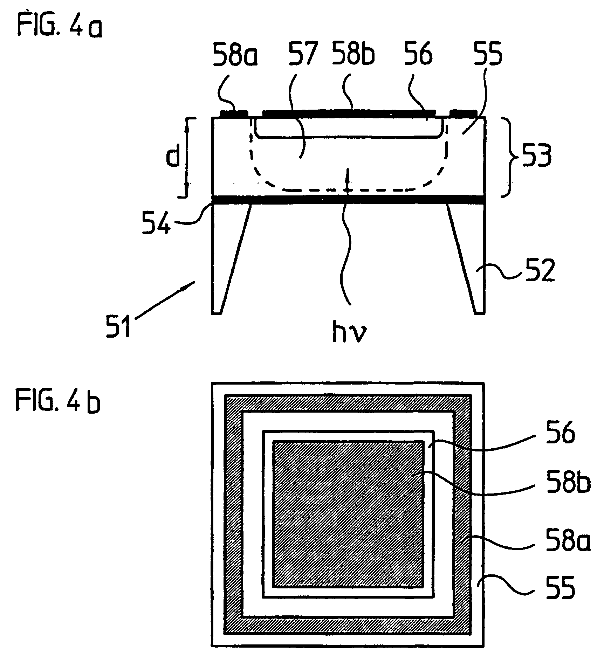

Eine weitere Ausführungsform des erfindungsgemäßen strahlungsempfindlichen Detektorelementes zeigen die Figuren 4a und 4b. Die dabei dargestellte Variante unterscheidet sich von derjenigen aus Figur 3 lediglich hinsichtlich der gewählten Art der Kontaktierung und der Form des Detektorelementes (51). So ist nunmehr vorgesehen, die beiden Kontaktelemente (58a, 58b) jeweils großflächig auf einem im Querschnitt quadratisch ausgebildeten Detektorelement (51) auszuführen. Hierbei ist auf der entgegengesetzt zur Strahlungseinfalls-Seite angeordneten Oberfläche eine quadratisch ausgebildete erste Kontaktelektrode (58b) mit einem der beiden Schichtbereiche (55, 56) unterschiedlicher Dotierung verbunden. Die zweite Kontaktelektrode (58a) ist ringförmig um die erste Kontaktelektrode (58b) angeordnet und mit dem zweiten Schichtbereich (55) verbunden. Durch eine derartige großflächige Kontaktieren lassen sich eventuell vorhandene, lokal unterschiedliche Empfindlichkeiten des Detektorelementes (51) vermeiden. Selbstverständlich sind auch alternative Geometrien für die großflächig ausgeführte Kontaktelektroden möglich, etwa rotationssymmetrisch angeordnete Kontaktelektroden etc..

Selbstverständlich lassen sich die verschiedenen erwähnten Materialien für die erfindungsgemäß dimensionierte Schichtanordnung aus den erläuterten Ausführungsbeispielen mit den unterschiedlichen Kontaktierungs-Arten kombinieren.

## Patentansprüche

1. Strahlungsempfindliches Detektorelement (1; 31; 51) mit
- einem aktiven Bereich (7; 27; 37; 57), der sich zwischen zwei aneinandergrenzenden Schichtbereichen (5, 6; 25, 26; 35, 36; 55, 56) einer Schichtanordnung (3; 33; 53) mit unterschiedlichen Ladungsträgern ausbildet und innerhalb dessen eine Umwandlung einfallender, elektromagnetischer Strahlung (hν) in elektrische Signale erfolgt und
- mindestens zwei Kontaktelementen (8a, 8b; 38a, 38b; 58a, 58b) zum Anschluß des Detektorelementes (1; 31; 51) an eine Auswerteschaltung (100), wobei die Kontaktelemente (8a, 8b; 38a, 38b; 58a, 58b) an einer Oberfläche in Kontakt mit den unterschiedlichen Schichtbereichen (5, 6; 25, 26; 35, 36; 55, 56) montiert sind, die gegenüber der strahlungsempfindlichen Oberfläche liegt, auf die die einfallende Strahlung (hν) auftrifft,
**dadurch gekennzeichnet,**
**dass** die Anordnung der Kontaktelemente (8a, 8b; 38a, 38b; 58a, 58b) an der zur einfallenden Strahlung (hv) abgewandten Seite des Detektorelements (1; 31; 51) in planarem Kontakt mit den unterschiedlichen Schichtbereichen (5, 6; 25, 26; 35, 36; 55, 56) ist.

2. Strahlungsempfindliches Detektorelement (1; 31; 51) nach Anspruch 1, **dadurch gekennzeichnet, dass** die Schichtanordnung (3; 33; 53) in Richtung der einfallenden Strahlung (hν) mit einer für die einfallende Strahlung (hv) transparenten Schicht (4; 54) versehen ist.

3. Strahlungsempfindliches Detektorelement (1; 31; 51) nach Anspruch 2, **dadurch gekennzeichnet, dass** die Schicht (4; 54) als SiO₂-Schicht ausgebildet ist.

4. Strahlungsempfindliches Detektorelement (1; 31; 51) nach Anspruch 1, **dadurch gekennzeichnet, dass** die Schichtanordnung (3; 33; 53) als epitaktisch aufgewachsene Silizium-Schicht ausgebildet ist, die mindestens zwei Schichtbereiche (5, 6; 25, 26; 35, 36; 55, 56) unterschiedlicher Dotierung aufweist.

5. Strahlungsempfindliches Detektorelement (1; 31; 51) nach Anspruch 4, **dadurch gekennzeichnet, dass** die epitaktisch aufgewachsene Silizium-Schicht Germanium-Ionen enthält.

6. Strahlungsempfindliches Detektorelement (31) nach Anspruch 1, **dadurch gekennzeichnet, dass** die Schichtanordnung (33) als dünne Halbleitermembran (d) ausgebildet ist, die Schichtbereiche (35, 36) unterschiedlicher Dotierung aufweist.

7. Strahlungsempfindliches Detektorelement (1; 31; 51) nach Anspruch 1 oder 6, **dadurch gekennzeichnet, dass** die der einfallenden Strahlung (hν) zugewandte Oberfläche mit einer strahlungsdurchlässigen Passivierungsschicht (34) zur Stabilisierung der elektrischen Eigenschaften versehen ist.

8. Strahlungsempfindliches Detektorelement (1; 31; 51) nach Anspruch 7, **dadurch gekennzeichnet, dass** die Passivierungsschicht (34) als SiO₂- oder Si₃N₄-Schicht ausgebildet ist.

9. Strahlungsempfindliches Detektorelement (31) nach Anspruch 6, **dadurch gekennzeichnet, dass** die Halbleitermembran (33) auf einem Trägersubstrat (32) angeordnet ist, das den gleichen thermischen Ausdehnungskoeffizienten aufweist wie die Halbleitermembran.

10. Strahlungsempfindliches Detektorelement (51) nach Anspruch 1, **dadurch gekennzeichnet, dass** mindestens eines der Kontaktelemente (58a, 58b) als flächiger Kontaktierungsbereich ausgebildet ist.

11. Strahlungsempfindliches Detektorelement (51) nach Anspruch 10 **dadurch gekennzeichnet, dass** einer der beiden Schichtbereiche (55, 56) der Schichtanordnung (53) eine größere Grundfläche aufweist als der jeweils andere Schichtbereich (55, 56) und der größere Schichtbereich (55, 56) mit einem flächigen Kontaktierungsbereich (58a, 58b) versehen ist, welcher über ein weiteres Kontaktelement (58a, 58b) mit der nachgeordneten Auswerteschaltung verbunden ist.

12. Verwendung eines strahlungsempfindlichen Detektorelementes (1; 31; 51) nach einem der vorangehenden Ansprüche in der Abtasteinheit einer lichtelektrischen Positionsmeßeinrichtung.

## Claims

1. Radiation-sensitive detector element (1; 31; 51) having
- an active region (7; 27; 37; 57) which is configured between two adjoining layer regions (5; 6; 25, 26; 35, 36; 55, 56) of a layer arrangement (3; 33; 53) with different charge carriers and within which conversion of incident electromagnetic radiation (hν) into electrical signals is effected and
- at least two contact elements (8a, 8b; 38a, 38b; 58a; 58b) for connecting the detector element (1; 31; 51) to an evaluation circuit (100), the contact elements (8a, 8b; 38a, 38b; 58a, 58b) being mounted on a surface in contact with the different layer regions (5, 6; 25, 26; 35, 36; 55, 56) which are situated opposite the radiation-sensitive surface on which the incident radiation (hν) impinges,
**characterised in that**
the arrangement of the contact elements (8a, 8b; 38a, 38b; 58a, 58b) is on the side of the detector element (1; 31; 51) which is orientated away from the incident radiation (hν), in planar contact with different layer regions (5, 6; 25, 26; 35, 36; 55, 56).

2. Radiation-sensitive detector element (1; 31; 51) according to claim 1, **characterised in that** the layer arrangement (3; 33; 53) is provided in the direction of the incident radiation (hν) with a layer (4; 54) which is transparent for the incident radiation (hν).

3. Radiation-sensitive detector element (1; 31; 51) according to claim 2, **characterised in that** the layer (4; 54) is configured as an SiO₂ layer.

4. Radiation-sensitive detector element (1; 31; 51) according to claim 1, **characterised in that** the layer arrangement (3; 33; 53) is configured as an epitaxially-grown silicon layer, which has at least two layer regions (5, 6; 25, 26; 35, 36; 55, 56) of different doping.

5. Radiation-sensitive detector element (1; 31; 51) according to claim 4, **characterised in that** the epitaxially-grown silicon layer contains germanium ions.

6. Radiation-sensitive detector element (31) according to claim 1, **characterised in that** the layer arrangement (33) is configured as a thin semiconductor membrane (d) which has layer regions (35, 36) of different doping.

7. Radiation-sensitive detector element (1; 31; 51) according to claim 1 or 6, **characterised in that** the surface orientated towards the incident radiation (hν) is provided with a radiation-permeable passivating layer (34) in order to stabilise the electrical properties.

8. Radiation-sensitive detector element (1; 31; 51) according to claim 7, **characterised in that** the passivating layer (34) is configured as an SiO₂ or Si₃N₄ layer.

9. Radiation-sensitive detector element (31) according to claim 6, **characterised in that** the semiconductor membrane (33) is disposed on a carrier substrate (32) which has the same thermal expansion coefficient as the semiconductor membrane.

10. Radiation-sensitive detector element (51) according to claim 1, **characterised in that** at least one of the contact elements (58a; 58b) is configured as a planar contacting region.

11. Radiation-sensitive detector element (51; 61) according to claim 10, **characterised in that** one of the two layer regions (55; 56) of the layer arrangement (53) has a larger area than the respectively other layer region (55; 56) and the larger layer region (55, 56) is provided with a planar contacting region (58a; 58b) which is connected to the subsequently disposed evaluation circuit via a further contact element (58a; 58b).

12. Use of a radiation-sensitive detector element (1; 31; 51) according to one of the preceding claims in the scanning unit of a photoelectric position measuring device.

## Revendications

1. Elément détecteur (1; 31; 51) sensible au rayonnement, comprenant
- une zone active (7; 27; 37; 57) qui est formée entre deux zones de couche (5, 6; 25, 26; 35, 36; 55, 56) contiguës d'un système de couches (3; 33; 53) ayant des porteurs de charge différents, et à l'intérieur de laquelle a lieu une conversion du rayonnement électromagnétique incident (hν) en signaux électriques, et
- au moins deux éléments de contact (8a, 8b; 38a, 38b; 58a; 58b) pour connecter l'élément détecteur (1; 31; 51) à un circuit de traitement (100), les éléments de contact (8a, 8b; 38a, 38b; 58a, 58b) étant montés sur une surface, en étant en contact avec les différentes zones de couche (5, 6; 25, 26; 35, 36; 55, 56), qui est située à l'opposé de la surface sensible au rayonnement, sur laquelle tombe le rayonnement incident (hν),
**caractérisé en ce que** l'agencement des éléments de contact (8a, 8b; 38a, 38b; 58a, 58b) se trouve sur la face de l'élément détecteur (1; 31; 51) qui est éloignée du rayonnement incident (hν) et est en contact planaire avec les différentes zones de couche (5, 6; 25, 26; 35, 36; 55; 56).

2. Elément détecteur (1; 31; 51) sensible au rayonnement selon la revendication 1, **caractérisé en ce que** le système de couches (3; 33; 53), dans la direction du rayonnement incident (hν), est pourvu d'une couche (4; 54) qui est transparente audit rayonnement incident (hν).

3. Elément détecteur (1; 31; 51) sensible au rayonnement selon la revendication 2, **caractérisé en ce que** la couche (4; 54) est réalisée comme couche SiO₂.

4. Elément détecteur (1; 31; 51) sensible au rayonnement selon la revendication 1, **caractérisé en ce que** le système de couches (3; 33; 53) est réalisé sous forme de couche de silicium obtenue par croissance épitaxiale, qui présente au moins deux zones de couche (5, 6; 25, 26; 35, 36; 55, 56) ayant des dopages différents.

5. Elément détecteur (1; 31; 51) sensible au rayonnement selon la revendication 4, **caractérisé en ce que** la couche de silicium obtenue par croissance épitaxiale contient des ions de germanium.

6. Elément détecteur (1; 31; 51) sensible au rayonnement selon la revendication 1, **caractérisé en ce que** le système de couches (33) est conformé en membrane à semi-conducteurs (d) mince, qui présente des zones de couche (35, 36) ayant des dopages différents.

7. Elément détecteur (1; 31; 51) sensible au rayonnement selon la revendication 1 ou 6, **caractérisé en ce que** la surface tournée vers le rayonnement incident (hν) est pourvue d'une couche de passivation (34) perméable au rayonnement, qui est destinée à stabiliser les propriétés électriques.

8. Elément détecteur (1; 31; 51) sensible au rayonnement selon la revendication 7, **caractérisé en ce que** la couche de passivation (34) est réalisée sous forme de couche SiO₂ ou de couche Si₃N₄.

9. Elément détecteur (31) sensible au rayonnement selon la revendication 6, **caractérisé en ce que** la membrane à semi-conducteurs (33) est disposée sur un substrat support (32) qui présente le même coefficient de dilatation thermique que la membrane à semi-conducteurs.

10. Elément détecteur (51) sensible au rayonnement selon la revendication 1, **caractérisé en ce qu'**au moins un des éléments de contact (58a, 58b) est réalisé sous la forme d'une zone de connexion plane.

11. Elément détecteur (51) sensible au rayonnement selon la revendication 10, **caractérisé en ce que** l'une des deux zones de couche (55, 56) du système de couches (53) présente une surface de base qui est plus grande que celle de l'autre zone de couche (55, 56), et que la zone de couche (55, 56) plus grande est pourvue d'une zone de connexion (58a, 58b) plane qui est connectée via un élément de contact (58a, 58b) supplémentaire au circuit de traitement branché à la suite.

12. Utilisation d'un élément détecteur (1; 31; 51) sensible au rayonnement selon une des revendications précédentes dans l'unité de palpage d'un dispositif de mesure de position optoélectronique.
